Europäisches Patentamt

European Patent Office

Office européen des brevets

(11) Publication number: **0 434 203 A2**

## (12) EUROPEAN PATENT APPLICATION

(21) Application number: **90312306.5**

(22) Date of filing: **09.11.90**

(51) Int. Cl.5: **H03D 7/14**

(30) Priority: **16.12.89 GB 8928439**

(43) Date of publication of application:
**26.06.91 Bulletin 91/26**

(84) Designated Contracting States:
**BE DE DK ES FR GR IT LU NL**

(71) Applicant: **STC PLC**
**1B Portland Place**
**London W1N 3AA(GB)**

(72) Inventor: **Rokos, George Hedley Storm**
**16, South Road**
**Bishop's Stortford, Herts CM23 3JH(GB)**

(74) Representative: **Dennis, Mark Charles et al**
**STC Patents West Road**
**Harlow Essex CM20 2SH(GB)**

(54) **Cross-coupled mixer stage for zero IF radio.**

(57) An arrangement for mixing r.f. signals with local oscillator signals wherein r.f. signals are fed to two separate balanced amplifiers the outputs of which are fed to two separate balanced mixer stages together with balanced local oscillator signals in quadrature, wherein the two outputs from each amplifier are fed one to each mixer stage.

Fig. 2.

## CROSS-COUPLED MIXER STAGE FOR ZERO IF RADIO

This invention relates to an arrangement for mixing r.f. signals with local oscillator signals in a zero IF or 'direct conversion' radio.

In one form of zero IF radio receiver local oscillator signals in phase quadrature at the carrier frequency are each separately mixed with the incoming modulated r.f. signal. The mixer outputs at the baseband are then low pass filtered and amplified before further signal processing is effected to achieve the required demodulation.

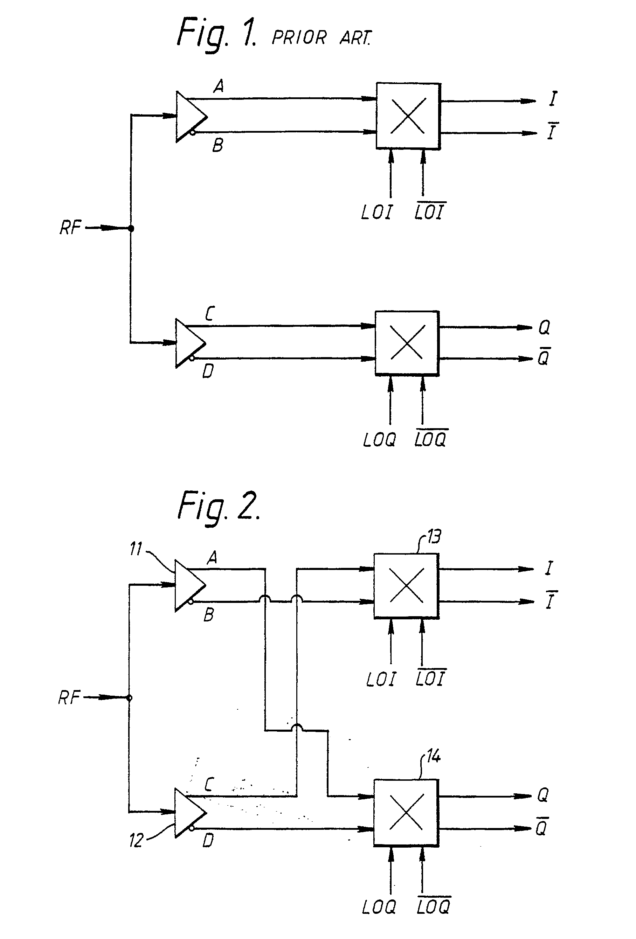

In a known zero IF radio receiver the incoming r.f. signals are fed to separate, balanced amplifiers the outputs of which are then fed to respective balanced mixer stages together with the respective quadrature local oscillator signals. The overall arrangement is shown in Fig. 1.

According to the present invention there is provided an arrangement for mixing r.f. signals with local oscillator signals wherein r.f. signals are fed to two separate balanced amplifiers with balanced outputs, which outputs are fed to two separate balanced mixer stages together with local oscillator signals in quadrature, characterised in that the two outputs from each amplifier are fed one to each mixer stage.

In a preferred embodiment of the invention the inphase and quadrature oscillator signals are balanced signals and the mixers are of the type commonly known as double balanced mixers.

An embodiment of the invention will now be described with reference to the accompanying drawings, in which:-

Fig. 1 is a block schematic of a prior art zero I.F. radio receiver mixer arrangement,

Fig. 2 is a block schematic of a zero I.F. radio receiver mixer arrangement according to the present invention, and

Fig. 3 is a circuit diagram of an embodiment of the arrangement of Fig. 2.

In the arrangement of Fig. 2 the incoming r.f. signals are fed to two separate balanced amplifiers 11, 12 which provide balanced outputs A, B and C, D. These balanced outputs are applied to two balanced mixer stages 13, 14 together with local oscillator signals LOI, LOI, LOQ and LOQ. LOQ and LOQ are in quadrature with LOI and LOI.

However, in contrast with the prior art, wherein the two outputs A & B of amplifier 11 are both fed to mixer 13, likewise C & D are fed to mixer 14, in the present invention the two outputs A & B from amplifer 11 are fed one to each mixer 13, 14, likewise the two outputs C, D from amplifier 12 are fed one to each mixer 13, 14.

The arrangement of Fig. 2 provides a reduction in the errors resulting from any mismatch differences in nominally identical components of the amplifying stages. It also provides a reduction in the output noise from each of the doubly balanced mixer stages. These improvements resulting from the reduced correlations between signals B and C, and between signals A and D, as compared with the correlations between signals A and B or between signals C and D in the prior art arrangement of Fig. 1.

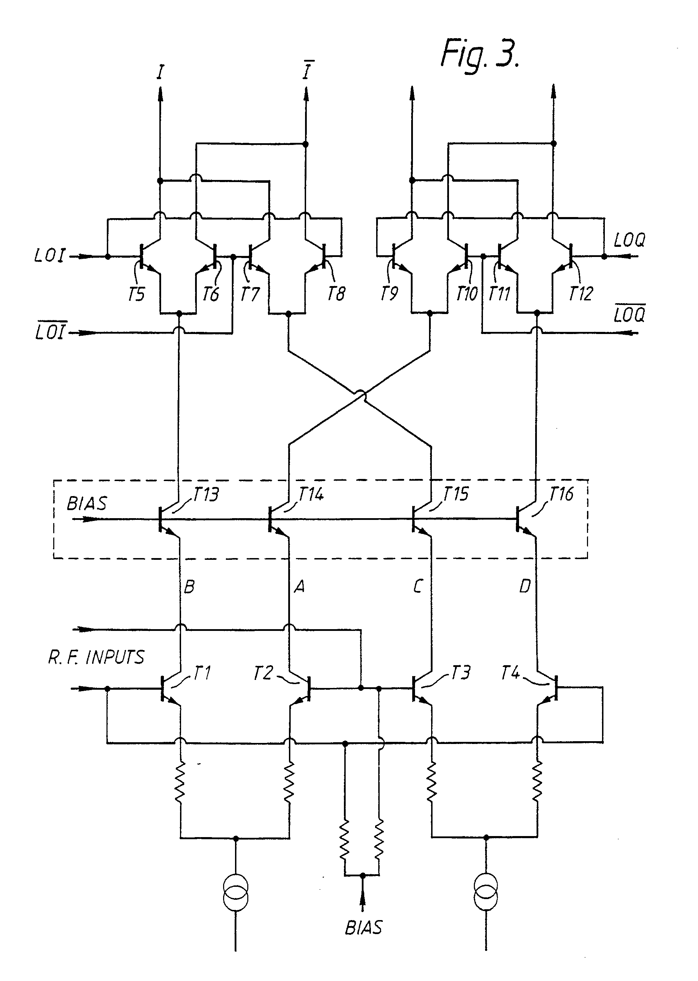

Fig. 3 shows a circuit arrangement wherein the balanced amplifiers and mixers may be incorporated in a single integrated circuit. The incoming r.f. signals are applied to two balanced amplifiers formed by pairs of transistors T1, T2 and T3, T4 respectively. As shown the r.f. inputs are balanced, however one side may be decoupled if desired. The balanced outputs A, B and C, D of the amplifiers are fed to two balanced mixers formed by respective sets of transistors T5 - T8 and T9 - T12, where they are mixed with balanced local oscillator signals LOI, LOI and LOQ, LOQ in quadrature. The outputs of the mixer stages are balanced baseband signals I, I and Q, Q. As explained with reference to Fig. 2, the two outputs A and B of one amplifier are fed one to each balanced mixer, likewise the outputs C & D are fed one to each mixer, i.e. outputs A and C are "cross-connected".

To improve isolation in the inputs to the mixer stages and optional cascode amplifier stage, provided by transistors T13-T16, may be included between the amplifiers and the mixers. This may be advantageous if separate r.f. input pre-amplifier stage is not included.

## Claims

1. An arrangement for mixing r.f. signals with local oscillator signals wherein r.f. signals are fed to two separate balanced amplifiers with balanced outputs, which outputs are fed to two separate balanced mixer stages together with local oscillator signals in quadrature, characterised in that the two outputs from each amplifier are fed one to each mixer stage.

2. An arrangement according to claim 1 characterised in that the quadrature oscillator signals are each balanced, and the mixers are both double balanced mixers.

3. An arrangement according to claim 2, characterised in that each of the differential amplifiers is a long-tailed pair transistor amplifier, and each of the double balanced mixers comprises two pairs of transistors with emitters connected in common, the current to each such pair of emitters being supplied from the collector of one of the transistors of a long-tailed pair.

4. An arrangement according to claim 3 including a cascode amplifying stage between the amplifier output connections and the mixer inputs.

Fig. 1. PRIOR ART.

Fig. 2.

4

Fig. 3.